(19) Europäisches Patentamt
European Patent Office
Office européen des brevets

(11) **EP 3 219 180 B1**

(12) **EUROPÄISCHE PATENTSCHRIFT**

(45) Veröffentlichungstag und Bekanntmachung des Hinweises auf die Patenterteilung:
**12.02.2020 Patentblatt 2020/07**

(21) Anmeldenummer: **15797067.4**

(22) Anmeldetag: **17.11.2015**

(51) Int Cl.:
***H05K 13/08*** *(2006.01)*

(86) Internationale Anmeldenummer:
**PCT/EP2015/076795**

(87) Internationale Veröffentlichungsnummer:
**WO 2016/113020 (21.07.2016 Gazette 2016/29)**

(54) **VERFAHREN UND SYSTEM ZUR BESTÜCKUNG VON LEITERPLATTEN**

METHOD AND SYSTEM FOR POPULATING PRINTED CIRCUIT BOARDS

PROCÉDÉ ET SYSTÈME DE MONTAGE DE CARTES DE CIRCUITS IMPRIMÉS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.01.2015 DE 102015200414**

(43) Veröffentlichungstag der Anmeldung:
**20.09.2017 Patentblatt 2017/38**

(73) Patentinhaber: **Siemens Aktiengesellschaft 80333 München (DE)**

(72) Erfinder:
• **PFAFFINGER, Alexander 81739 München (DE)**
• **ROYER, Christian 85521 Ottobrunn (DE)**

(56) Entgegenhaltungen:
EP-A1- 0 478 360            WO-A1-2014/005744
DE-A1-102011 076 565

**Beschreibung**

Die vorliegende Erfindung betrifft ein Verfahren und ein System zur Bestückung von Leiterplatten. Dabei wird ein Bestückungssystem mit mehreren Bestückungslinien vorausgesetzt, die jeweils dazu eingerichtet sind, eine Leiterplatte mit Bauelementen zu bestücken.

Eine elektronische Baugruppe umfasst eine Leiterplatte und Bauelemente, die auf ihr mechanisch und elektrisch befestigt sind. Zur Herstellung der fertigen Leiterplatte werden die Bauelemente mittels eines Bestückungsautomaten (Pick and Place) auf der Leiterplatte abgelegt und anschließend in einem Reflow-Ofen mit ihr verlötet. Mehrere Bestückungsautomaten können im Rahmen einer Bestückungslinie nacheinander durchlaufen werden. Zur Herstellung vieler Leiterplatten kann ein Bestückungssystem verwendet werden, das mehrere Bestückungslinien umfasst.

Der Bestückungsautomat kann nur mit einer vorbestimmten Anzahl unterschiedlicher Bauelementetypen ausgerüstet werden. Eine Zusammensetzung von Bauelementetypen am Bestückungsautomat wird Rüstung genannt. Mit einer Rüstung kann nur eine beschränkte Anzahl unterschiedlicher Leiterplatten gefertigt werden. Üblicherweise sollen jedoch Leiterplatten von mehr unterschiedlichen Leiterplattentypen gefertigt werden, als mittels einer Rüstung möglich ist, sodass die Rüstung während der Produktion geändert werden muss.

Ein Umrüsten, also ein Auswechseln einer Rüstung an einem Bestückungsautomaten gegen eine andere, ist zwar kein besonders aufwändiger Vorgang, jedoch werden dafür auswechselbare Rüsttische (Wechseltische) verwendet, die kostspielig sind und deren vorangehende Bestückung mit Bauelementen vorbestimmter Bauelementetypen zeit- und arbeitsintensiv sein kann.

Es wird daher üblicherweise angestrebt, wenigstens eine Festrüstung und möglichst wenige variable Rüstungen bereitzustellen. Die Zuordnung von Bauelementetypen zur Festrüstung bleibt dabei meistens in einem vorbestimmten Planungshorizont, der beispielsweise ca. 6 bis 12 Monate betragen kann, konstant. Variable Rüstungen bleiben in ihrer Zusammensetzung von Bauelementetypen üblicherweise sehr viel kürzer, beispielsweise ca. 1 bis 5 Tage, unverändert.

Für eine gegebene Menge von Leiterplatten unterschiedlicher Leiterplattentypen, die mittels einer Bestückungslinie bestückt werden sollen, wird üblicherweise versucht, eine Festrüstung zu bestimmen, die die Bestückung möglichst vieler Leiterplatten bzw. Leiterplattentypen ermöglicht.

DE 10 2012 220 904 A1 betrifft ein Verfahren zur Bestimmung einer möglichst vorteilhaften Festrüstung für eine Bestückungslinie. Dieses Verfahren berücksichtigt jedoch nicht, dass mehrere Bestückungslinien eines Bestückungssystems idealerweise in ihren zugeordneten Leiterplattentypen aufeinander abgestimmt werden sollten, um die parallele Produktion von Leiterplatten unterschiedlicher Leiterplattentypen möglichst effizient zu gestalten. Bei der Anwendung des Verfahrens auf mehrere Bestückungslinien eines Bestückungssystems nacheinander kann sich daher eine unvorteilhafte Verteilung ergeben, die einen Teil der Kapazität des Systems ungenutzt lässt.

EP 0 478 360 A1 betrifft die Arbeitsverteilung an einer Fertigungslinie bei der Bestückung von Leiterplatten.

DE 10 2011 076 565 A1 schlägt ein Verfahren zur Zuordnung von Leiterplatten auf Bestücklinien zur Bestückung der Leiterplatten mit Bauelementen vor.

WO 2014/005 744 A1 zeigt eine Technik zur Zuordnung von Leiterplatten auf Bestückungslinien.

Der Erfindung liegt die Aufgabe zugrunde, ein verbessertes Verfahren, ein Computerprogrammprodukt und ein System zur Bestückung von Leiterplatten anzugeben, die eine effizientere Bestückung auf einem Bestückungssystem mit mehreren Bestückungslinien erlaubt. Die Erfindung löst diese Aufgabe mittels der Gegenstände der unabhängigen Ansprüche. Unteransprüche geben bevorzugte Ausführungsformen wieder.

Zur Bestückung von Leiterplatten auf einem Bestückungssystem mit mehreren Bestückungslinien sind Rüstfamilien mit zugehörigen Rüstungen vorgesehen, wobei jeder Rüstfamilie eine Anzahl Leiterplattentypen und jeder zugeordneten Rüstung eine Anzahl Bauelementetypen zugeordnet ist, sodass eine Leiterplatte eines Leiterplattentyps einer Rüstfamilie mittels Bauelementen der Bauelementetypen der Rüstung an einer Bestücklinie bestückt werden kann. Vorräte von Bauelementen der Bauelementtypen einer Rüstung können mittels Rüsttischen an der Bestückungslinie bereitgestellt werden. Dabei wird ein Rüsttisch einer Variantenrüstung nur einmal und ein Rüsttisch einer Festrüstung mehrfach an einer Bestückungslinie eingesetzt.

Die Variantenrüstung wird für die Bestückung einer vorbestimmten Menge von Leiterplattentypen auf einem oder mehreren Rüsttischen realisiert, indem die Rüsttische mit Vorräten benötigter Bauelemente ausgestattet werden. Anschließend wird die Variantenrüstung an einer Bestückungslinie angebracht, die Leiterplatten werden bestückt und die Variantenrüstung wird wieder von der Bestückungslinie entfernt. Danach wird die Variantenrüstung ab- oder umgerüstet, indem wenigstens. Ein weiterer Einsatz der Variantenrüstung, also der Rüsttische in der gleichen Konfiguration, ist nicht vorgesehen.

Die Festrüstung wird auf die gleiche Weise auf einem oder mehreren Rüsttischen realisiert und an einer Bestückungslinie angebracht, um vorbestimmte Leiterplattentypen zu bestücken. Nach dem Ende dieser Bestückung wird die Festrüstung jedoch nicht abgerüstet, sondern bereitgehalten, um in der gleichen Konfiguration erneut an einer Bestückungslinie eingesetzt zu werden. Eine Änderung einer Festrüstung wird üblicherweise innerhalb eines Planungshorizonts, der beispielsweise ca. 6 bis 12 Monate betragen kann, nicht durchgeführt. Die Festrüstung kann innerhalb dieser Zeit sehr häufig an einer oder an wechselnden Bestückungslinien eingesetzt werden. Zwischen zwei Einsätzen derselben Festrüstung können eine oder mehrere Varianten- oder Festrüstungen an einer Bestückungslinie angebracht werden.

Ein Verfahren zum Bestücken von Leiterplatten umfasst Schritte des Erfassens von Aufträgen jeweils zur Bestückung einer Stückzahl Leiterplatten eines Leiterplattentyps mit Bauelementen vorbestimmter Bauelementetypen, des Zuordnens von Leiterplattentypen der erfassten Aufträge zu einer vorbestimmten Anzahl Festrüstungs-Rüstfamilien, des Optimierens der Zuordnung derart, dass eine auf alle Bestückungslinien das Bestückungssystems bezogene Kennzahl möglichst optimiert ist, und des Bestückens der Leiterplatten auf einer der Bestückungslinien unter Verwendung einer der bestimmten Festrüstungen.

Durch dieses Optimieren der Zuordnung von Leiterplatten zu Bestückungslinien kann das Bestückungssystem in verbesserter Weise ausgelastet werden. Durch das Betrachten der dem gesamten Bestückungssystem zugeordneten Kennzahl kann die gesamte Produktivität wichtiger als das ausgewogene Betreiben der Bestückungslinien sein. Ungleichmäßigkeiten in der Auslastung können später beim Bilden von Variantenrüstungen ausgeglichen werden. Das Bestückungssystem kann verbessert ausgelastet werden und die Produktivität des Bestückungssystems kann gesteigert sein. Daraus können sich Kostenvorteile für den Betreiber des Bestückungssystems oder einen Auftraggeber ergeben.

Dabei kann die Kennzahl eine Bestückungszeit der Leiterplatten umfassen, deren Aufträge mittels der Festrüstungen bearbeitet werden können. Die Kennzahl kann dabei Produktionszeit genannt werden. Die Produktionszeit kann im Sinne der Optimierung möglichst maximiert werden, um die Festrüstungen so zu bestimmen, dass sie zur Bestückung möglichst vieler Leiterplatten - gleicher oder unterschiedlicher Leiterplattentypen - verwendet werden können. Eine Stillstandszeit, in der die Bestückungslinie nicht arbeitet, kann minimiert sein.

Die Kennzahl kann auch eine Anzahl Aufträge umfassen, die mittels der bestimmten Festrüstung bearbeitet werden können. Je größer die Zahl der Aufträge ist, desto produktiver kann die Bestückungsanlage betrieben werden.

In einer besonders bevorzugten Ausführungsform umfasst die Kennzahl eine Zahl von zu fertigenden Aufträgen pro Leiterplattentyp, der einer Bestückungslinie zugeordnet ist. In diesem Fall wird die Kennzahl auch Orderzahl genannt. Untersuchungen haben gezeigt, dass durch Optimierung auf die Orderzahl die Elemente des Bestückungssystems in verbesserter Weise ausgelastet werden können.

Es ist besonders bevorzugt, dass die Zuordnung mittels Gemischt Ganzzahliger Programmierung erfolgt. Die Gemischt Ganzzahlige Programmierung stellt einen globalen Optimierungsansatz dar, der leicht erweiterbar ist und für den kommerzielle Lösungsverfahren bzw. Lösungsvorrichtungen erhältlich sind. Mittels Gemischt Ganzzahliger Programmierung können in einer Vielzahl möglicher Lösungen globale Maxima gefunden werden, sodass eine besonders gute Optimierung gefunden werden kann. Erhältliche Verfahren bzw. Vorrichtungen zur Gemischt Ganzzahligen Programmierung werden laufend verbessert, sodass zu erwarten ist, dass zukünftig noch bessere Optimierungsergebnisse erzielbar sein werden.

Vorteilhafterweise ist bei der Gemischt Ganzzahligen Programmierung für eine bestimmte Zuordnung jeweils bekannt, wie hoch die Zuordnungsgüte im Vergleich zu einer maximal erreichbaren Zuordnungsgüte ist. Ein Unterschied zwischen diesen beiden Kennzahlen wird auch "Gap" genannt. Dadurch kann die Optimierung bevorzugterweise dann abgebrochen werden, wenn eine vorbestimmte Zuordnungsgüte erreicht ist oder wenn der Gap ausreichend klein ist. Alternativ oder zusätzlich kann das Optimieren dann abgebrochen werden, wenn während einer vorbestimmten Bearbeitungszeit keine Zuordnung gefunden werden kann, deren Zuordnungsgüte die vorgegebenen Kriterien erfüllt. Dadurch kann verhindert werden, dass eine zu hoch gewählte Zuordnungsgüte oder ein zu klein gewählter Gap die Bestimmung einer Zuordnung in angemessener Zeit verhindert.

Die Zuordnung wird bevorzugterweise derart bestimmt, dass Leiterplatten, die mittels der bestimmten Festrüstung nicht bestückt werden können, mittels einer Variantenrüstung innerhalb einer vorbestimmten Produktionszeit bestückt werden.

Das angegebene Verfahren bestimmt allgemein nur Rüstungen, die insbesondere als Festrüstungen verwendet werden können. Es ist jedoch bevorzugt, dass die oben genannte Zuordnung derart bestimmt bzw. optimiert wird, dass Leiterplatten, die mittels der bestimmten Rüstung nicht bestückt werden können, mittels einer anderen Rüstung innerhalb einer vorbestimmten Produktionszeit bestückt werden können. Diese andere Rüstung kann insbesondere eine Variantenrüstung umfassen.

Anders ausgedrückt ordnet das Verfahren die Leiterplattentypen einem Festrüstungs- oder einem variablen Rüstungsanteil zu, wobei sichergestellt ist, dass auch die Leiterplatten des variablen Rüstungsanteils innerhalb der vorbestimmten Produktionszeit bestückt werden können. So kann sichergestellt sein, dass die Festrüstung nicht so bestimmt wird, dass ein Zeitbedarf, der mit dem verbleibenden variablen Rüstungsanteil verbunden ist, die Vorteile der Festrüstung in Frage stellen.

In einer Ausführungsform können Teilmengen der Leiterplatten eines Leiterplattentyps unterschiedlichen Bestückungslinien zugewiesen werden. Soll beispielsweise eine besonders große Stückzahl Leiterplatten eines Leiterplattentyps bestückt werden, so können mehrere Bestückungslinien parallel oder nacheinander Teile dieses Auftrags erfüllen.

Die Zuordnung erfolgt bevorzugt derart, dass ein Platzverbrauch der Bauelementetypen, die im Rahmen der bestimmten Festrüstung einer Bestückungslinie zugeordnet sind, nur einen vorbestimmten Anteil eines zur Verfügung stehenden Platzes erfordert. Dieser Platz wird üblicherweise in Spuren ausgedrückt, wobei eine Spur beispielsweise 8 mm breit sein kann. Ein Rüsttisch umfasst beispielsweise 40 Spuren und ein Bestückungsautomat bietet Platz für 2 Rüsttische. In diesem Beispiel beträgt der zur Verfügung stehende Platz insgesamt 640 mm, wobei die Grenzen der Rüsttische berücksichtigt werden müssen. Es kann beispielsweise gefordert sein, dass die bestimmte Rüstung nicht mehr als ca. 90% dieses Platzes (in obigem Beispiel nicht mehr als 36 Spuren) einnimmt.

Ein Computerprogrammprodukt umfasst Programmcodemittel zur Durchführung des beschriebenen Verfahrens, wenn es auf einer Verarbeitungseinrichtung abläuft oder auf einem computerlesbaren Medium gespeichert ist. Die Verarbeitungseinrichtung kann insbesondere einen programmierbaren Mikrocomputer umfassen.

Ein Bestückungssystem zum Bestücken von Leiterplatten, umfasst mehrere Bestückungslinien und eine Verarbeitungseinrichtung, die dazu eingerichtet ist, das oben beschriebene Verfahren durchzuführen, um Leiterplatten auf einer der Bestückungslinien unter Verwendung einer der bestimmten Festrüstungen zu bestücken.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:

Fig. 1    ein Bestückungssystem; und

Fig. 2    eine Veranschaulichung von Rüstfamilien an einer Bestückungslinie von Fig. 1;

darstellt.

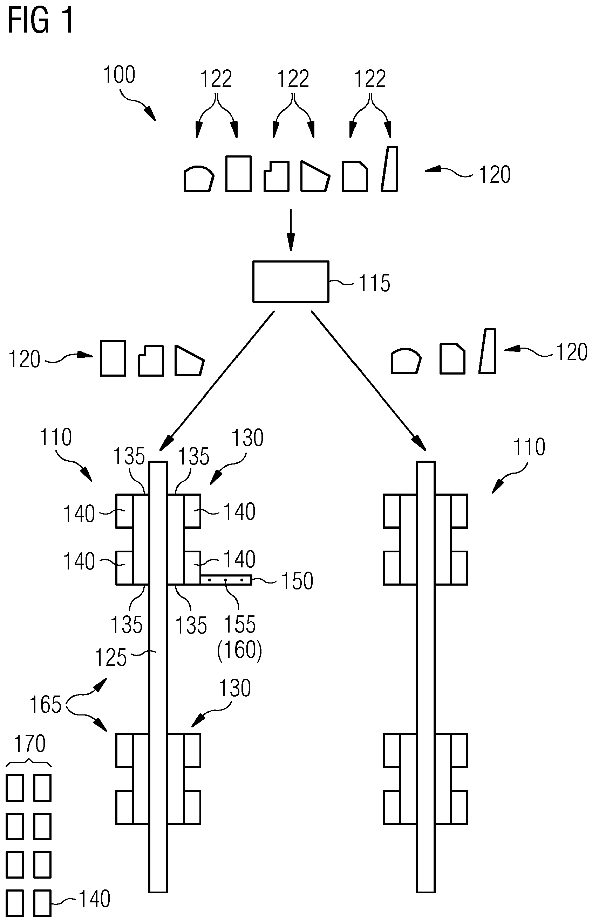

Figur 1 zeigt ein beispielhaftes Bestückungssystem 100. Das Bestückungssystem 100 umfasst eine oder mehrere Bestückungslinien 110 und eine Verarbeitungs- oder Steuereinrichtung 115. Jede Bestückungslinie 110 umfasst ein optionales Transportsystem 125 sowie einen oder mehrere Bestückungsautomaten 130. Jeder Bestückungsautomat 130 umfasst einen oder mehrere Bestückungsköpfe 135, die jeweils dazu eingerichtet sind, von einem Rüsttisch 140 Bauelemente 155 aufzunehmen und an einer vorbestimmten Position auf der Leiterplatte 120 zu positionieren, die sich auf dem Transportsystem 125 befindet. Während des Bestückungsvorgangs steht die Leiterplatte 120 bezüglich des Bestückungsautomaten 130 üblicherweise still.

Die Rüsttische 140 umfassen jeweils eine Vielzahl Zuführungseinrichtungen 150, von denen in Figur 1 exemplarisch nur eine dargestellt ist. Jede Zuführungseinrichtung 150 hält einen Vorrat von Bauelementen 155 eines vorbestimmten Bauelementetyps 160 bereit. Für die Bauelemente 155 hat die Zuführungseinrichtung 150 üblicherweise ein Fassungsvermögen, das in Spuren ausgedrückt werden kann. Eine Spur ist für gewöhnlich 8 mm breit und die Zahl der Spuren eines Rüsttischs 140 ist beschränkt, beispielsweise auf 40. Bauelemente 155 des gleichen Bauelementetyps 160 sind üblicherweise bereitgestellt in einem Gurt, auf einem Tablett oder in einer Röhre. Jeder Bauelementetyp 160 erfordert an der Zuführungseinrichtung 150 und am Rüsttisch 140 eine vorbestimmte Anzahl Spuren, die üblicherweise aneinander angrenzen.

Gewöhnlich kann eine Zuführungseinrichtung 150 zur Bereithaltung von Bauelementen 155 unterschiedlicher Bauelementetypen 160 konfiguriert werden und üblicherweise können unterschiedliche Zuführungseinrichtungen 150 an einem Rüsttisch 140 angebracht werden. Vorliegend wird vereinfachend davon ausgegangen, dass ein Vorrat von Bauelementen 155 eines Bauelementetyps 160 an einer Zuführungseinrichtung 150 praktisch unendlich groß ist, ein Nachrüsten also nicht erforderlich ist.

Wird am Bestückungsautomaten 130 ein Bauelement 155 eines Bauelementetyps 160 benötigt, der nicht an einem der Rüsttische 140 vorhanden ist, so wird üblicherweise nicht die Zuordnung von Bauelementen 155 an einem der angebrachten Rüsttische 140 verändert, sondern der Rüsttisch 140 wird komplett gegen einen anderen, passend bestückten Rüsttisch 140 ausgetauscht. Das Bestücken eines nicht an der Bestückungslinie 110 angebrachten Rüsttischs 140 mit Bauelementen 155 wird Vorrüstung genannt und kann eine Bearbeitungszeit im Bereich von einer oder mehreren Stunden, beispielsweise ca. 6-10 Stunden, erfordern.

Da ein Wechsel von Rüsttischen 140 an der Bestückungslinie 110, ein so genannter Rüstwechsel, üblicherweise mit einem Produktionsstillstand verbunden ist, wird angestrebt, Wechsel der Rüsttische 140 möglichst selten durchzuführen. Da ferner die Rüsttische 140 kostspielig sind und das Umrüsten eines Rüsttischs 140 aufwändig und langwierig sein kann, wird weiter versucht, möglichst wenige Rüstungen zu bilden, um eine vorbestimmte Produktionsmenge von Leiterplatten 120 vorbestimmter Leiterplattentypen 122 zu fertigen. Die Produktionsmenge umfasst hier mehrere Leiterplattentypen 122, von denen jeweils eine vorbestimmte Stückzahl Leiterplatten 120 mit Bauelementen 155 vorbestimmter Bauelementetypen 160 bestückt werden soll. Beispielsweise können 300 Leiterplatten 120 eines ersten Leiterplattentyps 122 und 200 Leiterplatten 120 eines zweiten Leiterplattentyps 122 bestückt werden.

Eine Rüstung 165, 170 umfasst eine Menge von Bauelementetypen 160 und wird realisiert durch einen oder mehrere Rüsttische 140, die mit Vorräten von Bauelementen 155 der Bauelementetypen 160 der Rüstung 165, 170 ausgestattet und an der Bestückungslinie 110 angebracht sind.

Der Rüstung 165, 170 ist eine Rüstfamilie 175 zugeordnet, die Leiterplattentypen 122 umfasst, von denen Leiterplatten 120 mittels Bauelementen 155 der Bauelementetypen 160 der Rüstung 165, 170 bestückt werden können. Eine Rüstfamilie 175 ist genau einer Rüstung 165, 170 zugeordnet und umgekehrt.

Um die Auslastung einer Bestückungslinie 110 zu erhöhen oder einen Bedarf an Rüsttischen 140 zu verringern ist es daher entscheidend, wie auf der Basis der zu bestückenden Leiterplattentypen 122 Rüstfamilien 175 gebildet werden. Bei der Bildung von Rüstungen 165, 170 bzw. Rüstfamilien 175 können Nebenbedingungen zu beachten sein, beispielsweise die Einhaltung einer begrenzten Fassungskapazität eines Rüsttisches 140 für Bauelementtypen 160 oder eine Gruppierung vorbestimmter Leiterplattentypen 160 in der gleichen Rüstfamilie 175, etwa aus Gründen der Verwendung bleihaltigen oder bleifreien Lötzinns.

Die Rüstungen können in Festrüstungen 165 und Variantenrüstungen 170 unterschieden werden.

Eine Variantenrüstung 170 wird üblicherweise nur für den einmaligen Einsatz an einer Bestückungslinie 110 aufgerüstet. Ist ein Bestückungsvorgang mit einer Variantenrüstung 170 abgeschlossen, so werden der oder die die zugeordneten Rüsttische 140 von der Bestückungslinie entfernt und in ihren Konfigurationen geändert, um eine andere Fest- oder Variantenrüstung 170 zu realisieren. Eine Variantenrüstung 165 bleibt üblicherweise nicht länger als einige Stunden oder Tage, üblicherweise jedenfalls nicht länger als eine Woche, auf Rüsttischen 140 realisiert.

Eine Festrüstung 165 kann hingegen mehrfach eingesetzt werden. Zwischen Einstätzen einer Festrüstung 165 werden die ihr zugeordneten Rüsttische 140 üblicherweise unverändert zwischengelagert, während die Produktion auf der Bestückungslinie 110 mittels anderer Rüsttische 140 weiter läuft. Die anderen Rüsttische 140 können insbesondere zu einer anderen Festrüstung 165 oder zu einer Variantenrüstung 170 gehören. Später können die Rüsttische 140 der zwischengelagerten Festrüstung 165 wieder an der Bestückungslinie 110 angebracht werden. Eine Festrüstung 170 bleibt üblicherweise über einen vorbestimmten Planungshorizont unverändert auf einem oder mehreren Rüsttischen 140 realisiert, wobei der Planungshorizont beispielsweise 6 bis 12 Monate betragen kann.

Die Rüstungen 165, 170 können nach Bedarf an der Bestückungslinie 110 ausgetauscht werden. Um eine Festrüstung 165 oder eine Variantenrüstung 170 zu realisieren wird üblicherweise ein Rüsttisch 140, während er nicht an der Bestückungslinie 110 angebracht ist, mit Vorräten von Bauelementen 155 vorbestimmter Bauelementetypen 160 aufgerüstet. Bereits aufgerüstete Bauelemente 155 nicht benötigter Bauelementetypen 160 können zuvor abgerüstet werden. Diese Umrüstung kann einen erheblichen Anteil manueller Arbeit umfassen und zeitaufwändig sein.

Um den mit einer Variantenrüstung 170 verbundenen Aufwand zu minimieren wird versucht in den Festrüstungen 165 möglichst viele Leiterplattentypen 122 aufzunehmen. Ein angestrebter Fall ohne Variantenrüstungen 170 ist in der Praxis jedoch kaum erzielbar.

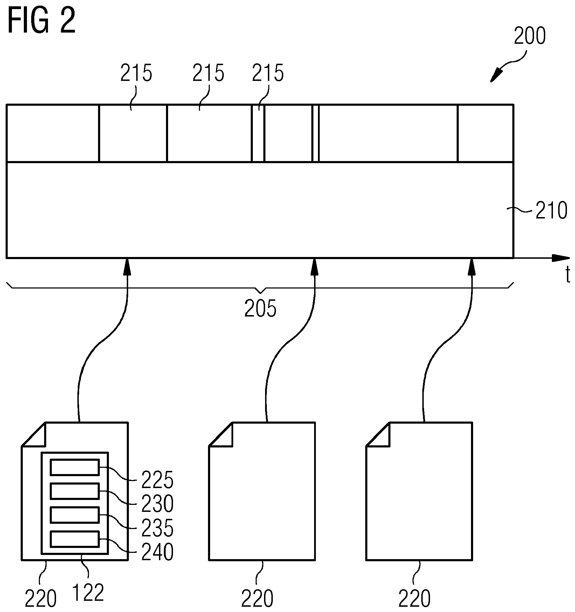

Figur 2 zeigt eine Veranschaulichung beispielhafter Rüstfamilien 175 an einer Bestückungslinie 110 aus Figur 1. Die Rüstfamilien 175 werden hier in eine Festrüstungs-Rüstfamilie 210, die einer Festrüstung 165 zugeordnet ist, und eine Variantenfertigungs-Rüstfamilie 215, die einer Variantenrüstung 170 zugeordnet ist, unterschieden. Innerhalb eines Planungshorizonts 205 können an der Bestückungslinie 110 im dargestellten Beispiel Leiterplattentypen 122 einer einzigen Festrüstungs-Rüstfamilie 210 oder einer einzigen Variantenfertigungs-Rüstfamilie 215 bestückt werden.

Es wird davon ausgegangen, dass zu Beginn des Planungshorizonts 205 mehrere Aufträge 220 vorliegen, die möglichst effizient auszuführen sind. Die Zahl der Aufträge wird Auftragszahl genannt. Jeder Auftrag 220 umfasst wenigstens einen Leiterplattentyp 122 und eine Stückzahl 225 zu bestückender Leiterplatten 120. Dem Leiterplattentyp 122 sind Bauelementetypen 160 zugeordnet, von denen Bauelemente 155 auf den einzelnen Leiterplatten 120 zu bestücken sind.

Einem Leiterplattentyp 122 können weitere Informationen zugeordnet sein. Beispielsweise können eine Anzahl 230 von Bauelementetypen 160, die auf jeder Leiterplatte 120 bestückt werden sollen, eine Anzahl 235 von Bestückpositionen einer Leiterplatte 120 oder eine Produktionszeit 240 für eine Leiterplatte 120, jeweils des Leiterplattentyps 122, angegeben sein. Die Anzahl der Bestückpositionen entspricht der Anzahl der auf einer Leiterplatte 120 des Leiterplattentyps 122 zu bestückenden Bauelemente 155, gleich welchen Bauelementetyps 160. Ferner kann eine Auftragszahl 245 angegeben sein, die angibt, wie viele Aufträge 220 zur Bestückung von Leiterplatten 120 eines Leiterplattentyps 122 in einem vorbestimmten Planungshorizont 205 vorliegen.

Durch den Einsatz von mathematischen Verfahren lassen sich für die Zuordnung von Leiterplattentypen 122 zu Festrüstungs-Rüstfamilien 210 bzw. zu Bestückungslinien 110 deutlich bessere Lösungen erzielen als mit bisher in der Praxis verwendeten Vorgehensweisen.

Zur Bestimmung einer optimierten Zuordnung von Leiterplattentypen 122 zu einer Festrüstungs-Rüstfamilie 210 kann eine automatische Optimierung verwendet werden. Dabei können unterschiedliche Optimierungsverfahren verwendet werden, beispielsweise auf der Basis von lokalen Suchverfahren oder metaheuristischen Algorithmen.

Bevorzugterweise wird jedoch ein IP-Modell (Integer Programmierung bzw. Integer Programm oder Gemischt Ganzzahliges Optimierungsmodell) verwendet. Eines der Hauptverfahren auf dem Gebiet der mathematischen Optimierung ist die Lineare Optimierung, die sich mit der Optimierung linearer Zielfunktionen über einer Menge befasst, die durch lineare Gleichungen und Ungleichungen eingeschränkt ist. Die Lineare Optimierung ist die Grundlage der Lösungsverfahren der (Gemischt) Ganzzahligen Linearen Optimierung.

Vorteile der Linearen Optimierung:

- Globaler Optimierungsansatz
- Leicht erweiterbar
- Sehr gute kommerzielle Standard-Solver (Ilog, Gurobi, Xpress), die in der Praxis weit verbreitet und bewährt sind
- Für eine ermittelte Lösung ist bekannt, wie weit sie maximal von der optimalen Lösung entfernt ist (Gap).

Im Folgenden werden Beispiele für IP-Formulierungen zur Optimierung der beschriebenen Zuordnung von Leiterplattentypen 122 zu Festrüstungs-Rüstfamilien 165 gegeben.

Indices

L       Menge der Bestücklinien
C       Menge der Bauelementetypen
$R_1$    Menge der auf der Bestückungslinie 1 bestückbaren Leiterplatten
$R_c$    Menge der Leiterplatten mit Bauelementetyp c
$F_l$    Menge der Festrüstungs-Rüstfamilien der Bestückungslinie l

Parameter

$Width_{c,l}$   Platzverbrauch eines Bauelementetyps c auf Bestückungslinie 1
$Cap_{c,l}$     Platzkapazität der Linie 1
$Order_r$       Stückzahl Aufträge für die Leiterplatte r
$Time_{r,l}$    Produktionszeit des Baugruppentyps r auf Bestückungslinie 1
$TimeLimit_l$   Maximale Gesamtproduktionszeit der Linie 1

Binärvariablen

$Assign_{r,l,f}$   hat den Wert 1, falls sich eine Baugruppe r auf der Linie 1 in der Festrüstungs-Rüstfamilie r befindet, andernfalls den Wert 0.

$AssignVar_{r,l}$   hat den Wert 1, falls eine Baugruppe r dem Nicht-Festrüstungsanteil auf der Linie 1 zugeordnet ist, andernfalls den Wert 0.

$Setup_{c,l,f}$   hat den Wert 1, falls der Bauelementetyp c auf der Bestückungslinie 1 in der Festrüstungs-Rüstfamilie f gerüstet werden muss, ansonsten den Wert 0

IP Formulierung

Die Optimierung kann bezüglich der Stückzahl 225 der Aufträge 220 zur Bestückung von Leiterplatten 120 bestimmter Leiterplattentypen 122 erfolgen:

$$maximize \sum_{r \in R} \sum_{l \in L} \sum_{f \in F_l} Order_r \, Assign_{r,l,f}$$

In einer anderen Ausführungsform kann die Optimierung auch bezüglich der Produktionszeit erfolgen:

$$maximize \sum_{r \in R} \sum_{l \in L} \sum_{f \in F_l} Time_r \, Assign_{r,l,f}$$

Andere Zieloptimierungskriterien sind ebenfalls möglich. Üblicherweise sind bei der Zuordnung bzw. deren Optimierung eine oder mehrere der folgenden Randbedingungen einzuhalten:

$$(1) \quad \sum_{l \in L} \sum_{f \in F_l} Assign_{r,l,f} + \sum_{l \in L} AssignVar_{r,l} = 1 \qquad r \in R$$

$$(2) \quad \sum_{r \in R_c} Assign_{r,l,f} \leq |R_c| Setup_{c,l,f} \qquad c \in C; l \in L; f \in F_l$$

$$(3) \quad \sum_{c \in C} Width_{c,l} Setup_{c,l,f} \leq Cap_l \qquad l \in L; f \in F_l$$

$$(4) \quad \sum_{r \in R} \sum_{f \in F_l} Time_{r,l} \, Assign_{r,l,f} + \sum_{r \in R} Time_{r,l} \, AssignVar_{r,l} \leq TimeLimit_j \qquad l \in L$$

$$(5) \quad Assign_{r,l,f} = 0 \qquad l \in L; \, f \in F_l; \, r \in R \backslash R_l$$

$$(6) \quad AssignVar_{r,l} = 0 \qquad l \in L; r \in R \backslash R_l$$

$$Setup_{c,l,f} \in \{0,1\} \qquad c \in C; \, l \in L; f \in F_l$$

$$Assign_{r,l,f} \in \{0,1\} \qquad c \in C; \, l \in L; f \in F_l$$

$$AssignVar_{r,l} \in \{0,1\} \qquad c \in C; \, l \in L$$

Zu diesen Bedingungen gelten folgende Erläuterungen:

Zu (1): Jeder Leiterplattentyp muss entweder einer Feströstung oder dem variablen Rüstanteil einer Bestückungslinie zugewiesen werden.

Zu (2): Ein Bauelementetyp muss in einer Feströstung f gehalten werden, wenn dieser Feströstung mindestens ein Leiterplattentyp zugewiesen ist, dem dieser Bauelementetyp zugewiesen ist.

Zu (3): Die Bauelementetypen einer Feströstung müssen in eine Rüstung passen, d. h. der Platzverbrauch (Spurverbrauch) dieser Bauelementetypen darf die Linienkapazität nicht übersteigen.

Zu (4): Die Summe der Bestückungszeiten der einer Bestückungslinie zugewiesenen Leiterplatten darf eine vorbestimmte Produktionszeitschranke der Bestückungslinie nicht überschreiten.

Zu (5), (6): Den Bestückungslinien dürfen nur Leiterplatten zugewiesen werden, die dort auch zulässig sind.

Es können auch alternative oder zusätzliche Bedingungen angegeben sein. Beispielsweise kann gefordert sein, dass eine Teilmenge der Leiterplattentypen 122 der selben Rüstfamilie 210, 215 zugeordnet werden muss, beispielsweise um jeweils eine Vorderseite und eine Rückseite der zugeordneten Leiterplatten 120 zu bestücken.

Eine Zuordnung von Leiterplattentypen 122 zu Bestückungslinien 110 entspricht einer Zuordnung von Leiterplattentypen 122 zu einer Rüstfamilie 210, 215, da durch die Rüstfamilie 210, 215 vorgegeben ist, welche Leiterplattentypen 160 auf einer Bestückungslinie 110 bestückt werden können. Die von einer Rüstfamilie 210, 215 umfassten Leiterplattentypen lassen sich vollständig mit Bauelementen 155 genau derjenigen Bauelementetypen 160 bestücken, die in der Rüstung 165, 170 zu finden sind, die der Rüstfamilie 210, 215 zugeordnet ist.

Die oben angegebene Zuordnung bzw. Optimierung, die bevorzugt mittels Gemischt Ganzzahliger Optimierung durchgeführt wird, gibt als Resultat bevorzugterweise nur die Zuordnung von Leiterplattentypen 160 zu einer Rüstung 165, 170 an. Es ist bevorzugt, dass diese Rüstung eine Festrüstung 165 ist. Die Leiterplattentypen 160, die mittels der bestimmten Rüstung 165, 170 nicht vollständig bestückt werden können, werden einem variablen Rüstungsanteil zugeordnet. Eine Zuordnung dieser Leiterplattentypen 160 an Variantenrüstungen kann in einem separaten Verfahren erfolgen.

Nach Abschluss der Bestimmung der Festrüstung 165 bzw. der Zuordnung von Stückzahlen 225 von Leiterplatten 155 zu Bestückungslinien 110 kann die Bestückung durchgeführt werden. Das Bestücken wird üblicherweise so durchgeführt, dass die Bauelemente 155 einzeln mittels Lötpaste an den Leiterplatten 120 fixiert werden. Anschließend können die bestückten Leiterplatten 155 in einem Reflow-Ofen fertig gestellt werden, in dem die Lötpaste vorübergehend aufgeschmolzen wird, sodass die Bauelemente 155 elektrisch und mechanisch mit Leiterbahnen an der Oberfläche der Leiterplatte 120 verbunden werden.

Obwohl die Erfindung im Detail durch das bevorzugte Ausführungsbeispiel näher illustriert und beschrieben wurde, ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1.  Verfahren zum Bestücken von Leiterplatten (120)

    - mittels eines Bestückungssystems (100) mit mehreren Bestückungslinien (110),
    - wobei Rüstfamilien (175) mit zugehörigen Rüstungen (165, 170) vorgesehen sind;
    - wobei jeder Rüstfamilie (175) eine Anzahl Leiterplattentypen (122) und jeder zugeordneten Rüstung (165, 170) eine Anzahl Bauelementetypen (160) zugeordnet ist,
    - sodass eine Leiterplatte (120) eines Leiterplattentyps (122) einer Rüstfamilie (175) mittels Bauelementen (155) der Bauelementetypen (160) der Rüstung (165, 170) an einer Bestücklinie bestückt werden kann;
    - wobei Vorräte von Bauelementen (155) der Bauelementtypen einer Rüstung (165, 170) mittels Rüsttischen (140) an der Bestückungslinie (110) bereitgestellt werden können,
    - wobei eine Rüstung (165, 170) auf einem oder mehreren Rüsttischen (140) realisiert wird, indem die Rüsttische (140) mit Vorräten benötigter Bauelemente (155) ausgestattet werden;
    - wobei die Rüstung (165, 170) eine Festrüstung (170) umfasst;
    - wobei die Festrüstung (165) an einer Bestückungslinie (110) angebracht wird, um vorbestimmte Leiterplattentypen (122) zu bestücken, die Festrüstung (165) nach dem Ende dieser Bestückung jedoch nicht abgerüstet, sondern bereitgehalten wird, um in der gleichen Konfiguration erneut an einer Bestückungslinie (110) eingesetzt zu werden;

    wobei das Verfahren folgende Schritte umfasst:

    - Erfassen von Aufträgen (220) jeweils zur Bestückung einer Stückzahl (225) Leiterplatten (120) eines Leiterplattentyps (122) mit Bauelementen (155) vorbestimmter Bauelementetypen (160) für einen vorbestimmten Planungshorizont;
    - Zuordnen von Leiterplattentypen (122) der erfassten Aufträge (220) zu einer vorbestimmten Anzahl Festrüstungs-Rüstfamilien (175);
    - wobei vorgesehen wird, dass in dem Planungshorizont eine Änderung einer Festrüstung (165) nicht durchgeführt wird;
    - Optimieren der Zuordnung derart, dass eine auf alle Bestückungslinien (110) das Bestückungssystems (100) bezogene Kennzahl maximiert ist; und
    - Bestücken der Leiterplatten (120) auf einer der Bestückungslinien (110) unter Verwendung einer der bestimmten Festrüstungen (165).

    **dadurch gekennzeichnet, dass** die Kennzahl

- eine Bestückungszeit der Leiterplatten (120), deren Aufträge (220) mittels der Festrüstungen (165) bearbeitet werden können; oder
- eine Anzahl Aufträge (220), die mittels der bestimmten Festrüstung (165) bearbeitet werden kann; oder
- eine Zahl von zu fertigenden Aufträgen (220) pro Leiterplattentyp (122), der einer Bestückungslinie (110) zugeordnet ist, umfasst.

2. Verfahren nach Anspruch 1, wobei die Optimierung mittels Gemischt Ganzzahliger Programmierung erfolgt.

3. Verfahren nach einem der vorangehenden Ansprüche, wobei die Zuordnung derart bestimmt wird, dass Leiterplatten (120), die mittels der bestimmten Festrüstung (165) nicht bestückt werden können, mittels einer Variantenrüstung (170) innerhalb einer vorbestimmten Produktionszeit bestückt werden können, wobei ein Rüsttisch (140) einer Variantenrüstung (215) nur einmal an einer Bestückungslinie (110) eingesetzt wird.

4. Verfahren nach einem der vorangehenden Ansprüche, wobei Teilmengen der Leiterplatten (120) eines Leiterplattentyps (122) unterschiedlichen Bestückungslinien (110) zugewiesen werden.

5. Verfahren nach einem der vorangehenden Ansprüche, wobei die Zuordnung derart erfolgt, dass ein Platzverbrauch der Bauelementetypen (160), die im Rahmen der bestimmten Festrüstung (165) einer Bestückungslinie (110) zugeordnet sind, nur einen vorbestimmten Anteil eines zur Verfügung stehenden Platzes erfordert.

6. Bestückungssystem (100) mit mehreren Bestückungslinien (110), zum Bestücken von Leiterplatten (120),

- wobei Rüstfamilien (175) mit zugehörigen Rüstungen (165, 170) vorgesehen sind;
- wobei jeder Rüstfamilie (175) eine Anzahl Leiterplattentypen (122) und jeder zugeordneten Rüstung (165, 170) eine Anzahl Bauelementetypen (160) zugeordnet ist,
- sodass eine Leiterplatte (120) eines Leiterplattentyps (122) einer Rüstfamilie (175) mittels Bauelementen (155) der Bauelementetypen (160) der Rüstung (165, 170) an einer Bestücklinie bestückt werden kann;
- wobei Vorräte von Bauelementen (155) der Bauelementtypen einer Rüstung (165, 170) mittels Rüsttischen (140) an der Bestückungslinie (110) bereitgestellt werden können,
- wobei eine Rüstung (165, 170) auf einem oder mehreren Rüsttischen realisiert wird, indem die Rüsttische (140) mit Vorräten benötigter Bauelemente (155) ausgestattet werden;
- wobei die Rüstung (165, 170) eine Festrüstung (165) umfasst,
- wobei die Festrüstung (165) an einer Bestückungslinie angebracht wird, um vorbestimmte Leiterplattentypen zu bestücken, die Festrüstung (165) nach dem Ende dieser Bestückung jedoch nicht abgerüstet, sondern bereitgehalten wird, um in der gleichen Konfiguration erneut an einer Bestückungslinie eingesetzt zu werden;

wobei das System eine Verarbeitungseinrichtung (115) umfasst, die dazu eingerichtet ist, folgende Schritte durchzuführen:

- Erfassen von Aufträgen (220) jeweils zur Bestückung einer Stückzahl (225) Leiterplatten (120) eines Leiterplattentyps (122) mit Bauelementen (155) vorbestimmter Bauelementetypen (160) für einen vorbestimmten Planungshorizont;
- Zuordnen von Leiterplattentypen (122) der erfassten Aufträge (220) zu einer vorbestimmten Anzahl Festrüstungs- Rüstfamilien (175);
- wobei vorgesehen wird, dass in dem Planungshorizont eine Änderung einer Festrüstung (165) nicht durchgeführt wird;
- Optimieren der Zuordnung derart, dass eine auf alle Bestückungslinien (110) das Bestückungssystems (100) bezogene Kennzahl maximiert ist; und
- Steuern des Systems (100), zum Leiterplatten (120) auf einer der Bestückungslinien (110) unter Verwendung einer der bestimmten Rüstungen (165) zu bestücken.

**dadurch gekennzeichnet, dass** die Kennzahl

- eine Bestückungszeit der Leiterplatten (120), deren Aufträge (220) mittels der Festrüstungen (165) bearbeitet werden können; oder
- eine Anzahl Aufträge (220), die mittels der bestimmten Festrüstung (165) bearbeitet werden kann; oder
- eine Zahl von zu fertigenden Aufträgen (220) pro Leiterplattentyp (122), der einer Bestückungslinie (110) zugeordnet ist, umfasst.

**Claims**

1. Method for populating printed circuit boards (120)

    - by means of a pick-and-place system (100) having a plurality of pick-and-place lines (110),
    - set-up families (175) with associated set-ups (165, 170) being provided;
    - a number of printed circuit board types (122) being assigned to each set-up family (175) and a number of component types (160) being assigned to each associated set-up (165, 170),
    - with the result that a printed circuit board (120) of a printed circuit board type (122) in a set-up family (175) can be populated by means of components (155) of the component types (160) in the set-up (165, 170) on a pick-and-place line;
    - stocks of components (155) of the component types in a set-up (165, 170) being able to be provided by means of set-up tables (140) on the pick-and-place line (110),
    - a set-up (165, 170) being implemented on one or more set-up tables (140) by equipping the set-up tables (140) with stocks of required components (155);
    - the set-up (165, 170) comprising a fixed set-up (170);
    - the fixed set-up (165) being fitted to a pick-and-place line (110), in order to populate predetermined printed circuit board types (122), but not the fixed set-up (165) being removed after the end of this population, but rather being held in order to be used again in the same configuration on a pick-and-place line (110);

    the method comprising the following steps of:

    - detecting orders (220) each for populating a quantity (225) of printed circuit boards (120) of a printed circuit board type (122) with components (155) of predetermined component types (160) for a predetermined planning horizon;
    - assigning printed circuit board types (122) of the detected orders (220) to a predetermined number of fixed set-up families (175);
    - it being provided that the planning horizon of a fixed set-up (165) is not changed;
    - optimizing the assignment in such a manner that a characteristic number based on all pick-and-place lines (110) of the pick-and-place system (100) is maximized; and
    - populating the printed circuit boards (120) on one of the pick-and-place lines (110) using one of the determined fixed set-ups (165),

    **characterized in that** the characteristic number comprises

    - a population time for the printed circuit boards (120) whose orders (220) can be processed using the fixed set-ups (165); or
    - a number of orders (220) which can be processed using the determined fixed set-up (165); or
    - a number of orders (220) to be produced for each printed circuit board type (122) assigned to a pick-and-place line (110) .

2. Method according to Claim 1, the optimization being carried out by means of mixed integer programming.

3. Method according to one of the preceding claims, the assignment being determined in such a manner that printed circuit boards (120) which cannot be populated using the determined fixed set-up (165) can be populated using a variant set-up (170) within a predetermined production time, a set-up table (140) of a variant set-up (125) being used only once on a pick-and-place line (110).

4. Method according to one of the preceding claims, subsets of the printed circuit boards (120) of a printed circuit board type (122) being allocated to different pick-and-place lines (110) .

5. Method according to one of the preceding claims, the assignment being carried out in such a manner that a space used by the component types (160), which are assigned to a pick-and-place line (110) within the scope of the determined fixed set-up (165), requires only a predetermined portion of an available space.

6. Pick-and-place system (100) having a plurality of pick-and-place lines (110) for populating printed circuit boards (120),

    - set-up families (175) with associated set-ups (165, 170) being provided;

- a number of printed circuit board types (122) being assigned to each set-up family (175) and a number of component types (160) being assigned to each associated set-up (165, 170),

- with the result that a printed circuit board (120) of a printed circuit board type (122) in a set-up family (175) can be populated by means of components (155) of the component types (160) in the set-up (165, 170) on a pick-and-place line;

- stocks of components (155) of the component types in a set-up (165, 170) being able to be provided by means of set-up tables (140) on the pick-and-place line (110),

- a set-up (165, 170) being implemented on one or more set-up tables by equipping the set-up tables (140) with stocks of required components (155);

- the set-up (165, 170) comprising a fixed set-up (165),

- the fixed set-up (165) being fitted to a pick-and-place line, in order to populate predetermined printed circuit board types, but the fixed set-up (165) not being removed after the end of this population, but rather being held in order to be used again in the same configuration on a pick-and-place line;

the system comprising a processing device (115) which is set up to carry out the following steps of:

- detecting orders (220) each for populating a quantity (225) of printed circuit boards (120) of a printed circuit board type (122) with components (155) of predetermined component types (160) for a predetermined planning horizon;

- assigning printed circuit board types (122) of the detected orders (220) to a predetermined number of fixed set-up families (175);

- it being provided that in the planning horizon of a fixed set-up (165) is not changed;

- optimizing the assignment in such a manner that a characteristic number based on all pick-and-place lines (110) of the pick-and-place system (100) is maximized; and

- controlling the system (100) to populate printed circuit boards (120) on one of the pick-and-place lines (110) using one of the determined set-ups (165),

**characterized in that** the characteristic number comprises

- a population time for the printed circuit boards (120) whose orders (220) can be processed using the fixed set-ups (165); or

- a number of orders (220) which can be processed using the determined fixed set-up (165); or

- a number of orders (220) to be produced for each printed circuit board type (122) assigned to a pick-and-place line (110) .

## Revendications

1. Procédé destiné au montage de cartes de circuit imprimé (120)

- au moyen d'un système de montage (100) comportant plusieurs chaînes de montage (110),

- dans lequel des familles d'équipement (175) comportant des équipements (165, 170) correspondants sont prévus ;

- dans lequel à chaque famille d'équipement (175) sont associés une pluralité de types de carte de circuit imprimé (122) et à chaque équipement associé (165, 170) sont associés une pluralité de types de composant (160),

- de sorte qu'une carte de circuit imprimé (120) d'un type de carte de circuit imprimé (122) d'une famille d'équipement (175) peut être montée au moyen de composants (155) des types de composant (160) de l'équipement (165, 170) au niveau d'une chaîne de montage ;

- dans lequel des stocks de composants (155) des types de composant d'un équipement (165, 170) peuvent être mis à disposition au moyen de postes d'équipement (140) au niveau de la chaîne de montage (110),

- dans lequel un équipement (165, 170) est réalisé sur un ou plusieurs postes de montage (140) en dotant les postes de montage (140) de stocks de composants (155) nécessaires ;

- dans lequel l'équipement (165, 170) comprend un équipement fixe (170) ;

- dans lequel l'équipement fixe (165) est mis en place au niveau d'une chaîne de montage (110) pour monter des types de carte de circuit imprimé (122) prédéterminés, l'équipement fixe (165) n'étant toutefois pas démonté à l'issue de ce montage, mais conservé pour être réinstallé dans la même configuration au niveau d'une chaîne de montage (110) ;

dans lequel le procédé comprend les étapes suivantes :

- acquisition de commandes (220) destinées respectivement au montage d'un nombre de pièces (225) de cartes de circuit imprimé (120) d'un type de carte de circuit imprimé (122) avec des composants (155) de types de composant (160) prédéterminés pour un horizon de planification prédéterminé ;
- association de types de carte de circuit imprimé (122) des commandes acquises (220) à un nombre prédéterminé de familles d'équipement en équipements fixes (175) ;
- dans lequel il est prévu de ne pas procéder à une modification d'un équipement fixe (165) dans l'horizon de planification ;
- optimisation de l'association de telle sorte qu'un indicateur se rapportant à toutes les chaînes de montage (110) du système de montage (100) est maximisé ; et
- montage des cartes de circuit imprimé (120) sur l'une des chaînes de montage (110) en utilisant l'un des équipements fixes (165) déterminés,

**caractérisé en ce que** l'indicateur comprend

- un temps de montage des cartes de circuit imprimé (120), dont les commandes (220) peuvent être traitées au moyen des équipements fixes (165) ; ou
- un nombre de commandes (220) qui peut être traité au moyen de l'équipement fixe (165) déterminé ; ou
- un nombre de commandes (220) à préparer par type de carte de circuit imprimé (122) qui est associé à une chaîne de montage (110).

2. Procédé selon la revendication 1, dans lequel l'optimisation est effectuée au moyen d'une programmation mixte en nombres entiers.

3. Procédé selon l'une des revendications précédentes, dans lequel l'association est déterminée de telle sorte que des cartes de circuit imprimé (120) qui ne peuvent pas être montées au moyen de l'équipement fixe (165) déterminé peuvent être montées au moyen d'un équipement alternatif (170) pendant un temps de production prédéterminé, dans lequel un poste d'équipement (140) d'un équipement alternatif (215) n'est mis en place qu'une seule fois au niveau d'une chaîne de montage (110) .

4. Procédé selon l'une des revendications précédentes, dans lequel des sous-ensembles des cartes de circuit imprimé (120) d'un type de carte de circuit imprimé (122) sont attribués à différentes chaînes de montage (110).

5. Procédé selon l'une des revendications précédentes, dans lequel l'association est effectuée de telle sorte qu'une occupation d'espace des types de composant (160) qui sont associés à une chaîne de montage (110) dans le cadre de l'équipement fixe (165) déterminé ne nécessite qu'une part prédéterminée d'un espace disponible.

6. Système de montage (100) comportant plusieurs chaînes de montage (110) pour le montage de cartes de circuit imprimé (120),

- dans lequel des familles d'équipement (175) comportant des équipements (165, 170) correspondants sont prévues ;
- dans lequel à chaque famille d'équipement (175) sont associés une pluralité de types de cartes de circuit imprimé (122) et à chaque équipement (165, 170) associé sont associés une pluralité de types de composant (160) ;
- de sorte qu'une carte de circuit imprimé (120) d'un type de carte de circuit imprimé (122) d'une famille d'équipement (175) peut être montée au moyen de composants (155) des types de composant (160) de l'équipement (165, 170) au niveau d'une ligne de montage ;
- dans lequel des stocks de composants (155) des types de composant d'un équipement (165,170) peuvent être mis à disposition au moyen de postes d'équipement (140) au niveau de la chaîne de montage (110),
- dans lequel un équipement (165, 170) est réalisé sur un ou plusieurs postes de montage (140) en dotant les postes de montage (140) de stocks de composants nécessaires (155) ;
- dans lequel l'équipement (165, 170) comprend un équipement fixe (165) ;
- dans lequel l'équipement fixe (165) est mis en place au niveau d'une chaîne de montage pour monter des types de carte de circuit imprimé prédéterminés, l'équipement fixe (165) n'étant toutefois pas démonté à l'issue de ce montage, mais conservé pour être réinstallé dans la même configuration au niveau d'une chaîne de montage ;

dans lequel le système comprend un dispositif de traitement (115) qui est conçu pour exécuter les étapes suivantes :

- acquisition de commandes (220) destinées respectivement au montage d'un nombre de pièces (225) de cartes de circuit imprimé (120) d'un type de carte de circuit imprimé (122) avec des composants (155) de types de composant prédéterminés (160) pour un horizon de planification prédéterminé ;
- association de types de carte de circuit imprimé (122) des commandes acquises (220) à un nombre prédéterminé de familles d'équipement en équipements fixes (175) ;
- dans lequel il est prévu de ne pas procéder à une modification d'un équipement fixe (165) dans l'horizon de planification ;
- optimisation de l'association de telle sorte qu'un indicateur se rapportant à toutes les chaînes de montage (110) du système de montage (100) est maximisé ; et
- commande du système (100) pour monter des cartes de circuit imprimé (120) sur l'une des chaînes de montage (110) en utilisant l'un des équipements (165) déterminés,

**caractérisé en ce que** l'indicateur comprend

- un temps de montage des cartes de circuit imprimé (120), dont les commandes (220) peuvent être traitées au moyen des équipements fixes (165) ; ou
- un nombre de commandes (220) qui peut être traité au moyen de l'équipement fixe (165) déterminé ; ou
- un nombre de commandes (220) à préparer par type de carte de circuit imprimé (122) qui est associé à une chaîne de montage (110).

FIG 1

# FIG 2

**EP 3 219 180 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102012220904 A1
- EP 0478360 A1
- DE 102011076565 A1
- WO 2014005744 A1